# EUROPEAN PATENT SPECIFICATION

(11) **EP 3 355 081 B1**
(45) Date of publication and mention of the grant of the patent: **19.06.2019**
(21) Application number: 17153478.7
(22) Date of filing: 27.01.2017
(51) Int. Cl.: G01T 1/24, H01L 27/146

(54) **DIRECT CONVERSION COMPOUND SEMICONDUCTOR TILE STRUCTURE**
DIREKTUMWANDLUNGS-VERBUND-LEITERPLATTENKACHELSTRUKTUR
STRUCTURE DE TUILE EN COMPOSÉ SEMI-CONDUCTEUR À CONVERSION DIRECTE

(43) Date of publication of application: 01.08.2018
(73) Proprietor: Detection Technology Oy, 90590 Oulu (FI)
(72) Inventor: Stång, Arsi, 90590 Oulu (FI)
(74) Representative: Papula Oy

(56) References cited:
- WO-A1-2015/012866
- US-A- 5 635 718
- US-A1- 2005 139 757
- US-A1- 2007 111 567

## Description

### BACKGROUND

Direct conversion compound semiconductor based detectors and detector arrays are utilized in radiation imaging in order to convert high energy radiation for example x-ray photons directly into electric charges. They are typically comprised of an x-ray photoconductor layer grown directly on top of a charge collector and a readout layer (such as room temperature semiconductors). The detectors are commonly utilized in arrays of multiple tiles such that an increased image size with improved resolution may be generated. Another reason for using the array with tiles, each tile having a relatively small size, is high costs of the direct conversion compound semiconductors.

The performance of the detectors can be important to many imaging applications. Linearity, uniformity, stability, and consistency may be relevant for peripheral tiles. For many applications, the imaging requirements can be very stringent. Vertical stacking of the tiles having a direct conversion compound semiconductor layer, an integrated circuit, IC, layer and a substrate layer may present some problematic conditions. For example, the heat generated by the IC can couple to the detector and introduce unwanted noise and thermal variation. Further, an array of the tiles requires very accurate and precise positioning with respect to the tiles. A tile should be carefully positioned to a right position in the array, especially with respect to the neighboring tiles. Furthermore, the detector made of the array needs to be maintained, for example in case of malfunction.

US2005/0139757 A1 discloses a device, comprising: a direct conversion compound semiconductor layer configured to convert high energy radiation photons into an electric current; an integrated circuit, IC, layer situated next to the direct conversion compound semiconductor layer and configured to receive the electric current and process the electric current; and a substrate layer situated next to the IC layer configured to conduct heat emitted from the IC layer; wherein the substrate layer comprises recesses at corners of a cross section of the substrate; and wherein the substrate layer further comprises electrical contacts between the corners, wherein the electrical contacts are connected to the IC layer through the substrate layer to receive the processed electric current. US5635718 discloses a radiation detecting device comprising a plurality of radiation detecting tiles and an assembly frame comprising elongated apertures.

### SUMMARY

This summary is provided to introduce a selection of concepts in a simplified form that are further described below in the detailed description. This summary is not intended to identify key features or essential features of the claimed subject matter, nor is it intended to be used to limit the scope of the claimed subject matter.

It is an object to provide a direct conversion compound semiconductor tile structure. The object is achieved by the features of the independent claim. Some embodiments are described in the dependent claims.

Many of the attendant features will be more readily appreciated as they become better understood by reference to the following detailed description considered in connection with the accompanying drawings.

### DESCRIPTION OF THE DRAWINGS

The present description will be better understood from the following detailed description read in light of the accompanying drawings, wherein:
FIG. 1 illustrates a schematic representation of a cross section side view of a tile showing a direct conversion compound semiconductor layer, an integrated circuit layer, and a substrate layer having shoulders and sliding contacts;
FIG. 2 illustrates a schematic representation of a tile;
FIG. 3 illustrates a schematic representation of a portion of an array of tiles on an assembly frame according to an embodiment;
FIG. 4 illustrates a schematic representation of an array of tiles on an assembly frame according to an embodiment;
FIG. 5 illustrates a schematic representation of a cross section side view of a detector assembly process illustrating an assembly frame according to an embodiment;
FIG. 6 illustrates a schematic representation of a cross section side view of a detector assembly process illustrating tiles on an assembly frame according to an embodiment;
FIG. 7 illustrates a schematic representation of a cross section side view of a detector assembly process illustrating an interconnection printed circuit board assembly, PCBA, having an assembly frame and tiles attached to it according to an embodiment;
FIG. 8 illustrates a schematic representation of a cross section side view of a detector assembly process illustrating a cover and the PCBA according to an embodiment;
FIG. 9 illustrates a schematic representation of a cross section side view of a detector assembly process illustrating a complete detector assembly according to an embodiment;
FIG. 10 illustrates a schematic representation of a top view of an assembly frame showing a recess for receiving tiles according to an embodiment;
FIG. 11 illustrates a schematic representation of a top view of an assembly frame showing adhesive strips for attaching tiles to an assembly frame according to an embodiment;
FIG. 12 illustrates a schematic representation of a top view of an assembly frame showing a tile assembled on a recess and attached by adhesive strips according to an embodiment;
FIG. 13 illustrates a schematic representation of a top view of an assembly frame showing an array of tiles assembled on a recess and attached by adhesive strips according to an embodiment; and
FIG. 14 illustrates a schematic representation of a cross section of a detector having the tiles according to an embodiment.

Like references are used to designate like parts in the accompanying drawings.

### DETAILED DESCRIPTION

The detailed description provided below in connection with the appended drawings is intended as a description of the embodiments and is not intended to represent the only forms in which the embodiment may be constructed or utilized. However, the same or equivalent functions and structures may be accomplished by different embodiments.

According to an embodiment, layers of a direct conversion compound semiconductor, an integrated circuit (IC) and a substrate establish a tile. An x-ray detector has an array of tiles. The substrate of the tile has recesses at the corners closest to an assembly frame, onto which the tile is attached. Consequently, a cross section side view of the tile forms a T-shape having shoulders as the recess. The shoulders allow a thermal path from the tile to the assembly frame onto which the tiles are assembled. Furthermore, the bottom surface of the substrate comprises sliding electric contact points. When assembling the array, a tile may be accurately slid to an appropriate location on the assembly frame, and electrical contact between the tile and recesses of the assembly frame can be maintained during sliding. The recesses of the assembly frame accommodate the tile so that the bottom part of the tile enters into the recess of the assembly frame and shoulders of the tile rest on the upper surface of the assembly frame.

The ceramic substrate of the tile has been configured to have contact with the assembly frame. It also allows electrical contact from the tile to read-out electronics of the assembly frame. From a side view, the ceramic substrate forms a T-shape. The shoulder of the T-shape allows the thermal path from the tile to the thermally controlled cooling plate below the assembly frame.

A single tile is attached to the assembly frame by using glue with a low adhesion force. Alternatively, the used glue may be thermally softened, for example if a tile needs to be replaced. A dual sided low adhesion tape may also be used instead of the glue. The adhesive force is low so that a single tile can be detached from the array later, for example for maintenance purposes

The embodiment enables maintainability and re-work of the detector array, for example in a case of a single or multiple tile malfunctions. An individual tile which malfunctions can be replaced without compromising the complete array functionality. Typical automatically die bonded arrays cannot be reworked easily or at all, causing expensive scrap on the full detector array assembly.

The sliding electrical contact at the assembly stage enables high accuracy for positioning each tile with respect to each other in the array. For example, a tolerance of +/- 5 micrometers (um) may be achieved for positioning the tile in the array. Tiles may be assembled against a nominal distance of 20 um with respect to each other's edges. Furthermore, shoulders of the tile enable the tile to fit in the assembly frame. They are also configured as a thermal path transferring heat away from the tile to the assembly frame. Consequently, thermal management of the detector plane may be improved. Furthermore, a distance between electronics of the tile and read-out electronics of the printed circuit board assembly onto which the assembly frame is attached is short, thus minimizing electrical noise.

An industrial scale assembly of detector arrays may be manufactured, and the detector array may be designed and manufactured modularly. The assembly tolerance of a tile in the array and thermal management of the tile may be improved.

Although the embodiments may be described and illustrated herein as being implemented in a direct conversion compound semiconductor, this is only an example implementation and not a limitation. As those skilled in the art will appreciate, the present embodiments are suitable for application in a variety of different types of detector semiconductor crystals such as Cadmium Telluride (CdTe), Cadmium Zinc Telluride CdZnTe, etc.

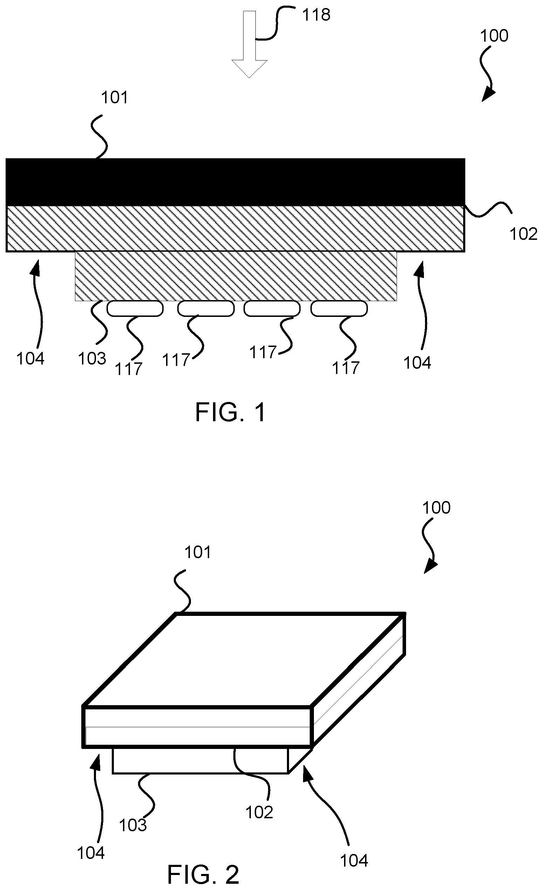

FIG. 1 illustrates a schematic representation of a cross section side view of a tile 100 in a z-axis (not shown in FIG. 1) direction showing a direct conversion compound semiconductor layer 101, an integrated circuit (IC) layer 102, and a substrate layer 103 having recesses 104 and sliding electrical contacts 117.

The direct conversion compound semiconductor layer 101 may also be referred to as a detector semiconductor crystal or a compound semiconductor. It is configured to convert high energy radiation such as x-ray photons into corresponding electronic currents that may be detected. The compound semiconductor layer 101 is the uppermost layer of the tile 100. The compound semiconductor layer 101 receives x-ray radiation 118. It should be noted that instead of x-rays, gamma ray radiation may be received. Under the compound semiconductor layer 101 there is the IC layer 102. The IC layer 102 may be an application-specific integrated circuit (ASIC). The ASIC may include microprocessors, memory blocks including ROM, RAM, EEPROM, flash memory, analog to digital converters, ADC, and other large building blocks. This kind of ASIC is often termed a SoC (system-on-chip). It may be configured using a hardware description language (HDL), such as Verilog or VHDL, to describe the functionality of ASICs. Instead of an ASIC, Field-programmable gate arrays (FPGA) may be used as programmable logic blocks and programmable interconnects allowing the same FPGA to be used in many different applications. The lowermost layer is the substrate layer 103. The substrate (also referred to as a wafer) may be a solid (usually planar) substance onto which a layer of another substance is applied and to which that second substance adheres. The substrate 103 may be a slice of material such as ceramics. These serve as the foundation upon which the IC electronic devices such as transistors, diodes, and especially integrated circuits (ICs) are deposited.

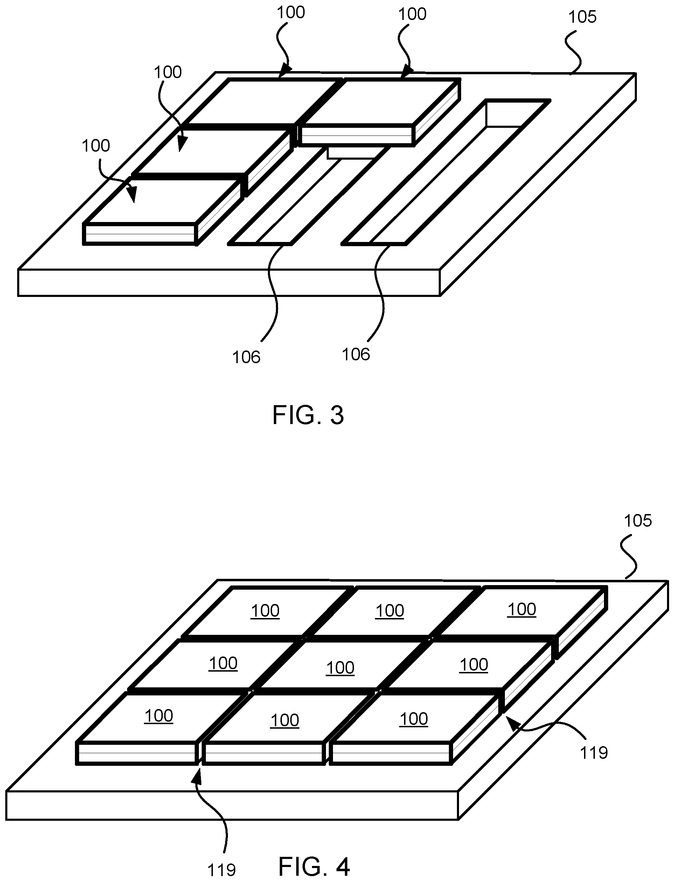

The substrate 103 comprises recesses 104 at the lowest corners which are closest to the assembly frame. The substrate layer 103 may also be referred to as a ceramics substrate. A side view of the cross section of the tile 100 forms a T-shape, wherein the recesses 104 appear as shoulders. The ceramics substrate 103 has been tooled to form the T-shape with the shoulders on two opposite sides of the tile 100. The recesses 104 enable the tile 100 to fit into an assembly frame, as illustrated for example in FIG. 3. The recesses 104 enable improvement in thermal conductivity, because material of the substrate layer 103 next to the recesses 104 is configured as a thermal path conducting heat from the tile 100 to the assembly frame. According to an embodiment, the substrate layer 103 may comprise thermal conductors, for example copper wires, which may be configured to the shoulder. The thermal conductivity from the tile 100 is mainly configured via the material next to the recesses 104 to the assembly frame. Heat may be conducted for example from the IC layer 102. The width of the recess 104 may be 1.3 mm - 1.5 mm, while the total width and the total length of the tile 100 are 10 mm x 10 mm. It should be noted that these are only exemplary measures, and other measures may be used to carve the recesses 104.

The substrate layer 103 comprises sliding electrical contacts 117. They are configured at the bottom of the substrate 103. They contact the assembly frame having elastic forced electrical contacts. Consequently, the tile 100 may be slid when inserted into a recess of the assembly frame. The tile 100 may be slid with a tolerance of +/-100 um. This enables very accurate further positioning of the tile 100 in the array, even after initial placement of the tile in the array. The sliding electrical contacts 117 may be conductive surfaces having a shape of rectangular, square, flat, semi-oval, semicircular, oval or circular. For example, they may be welded onto the bottom of the tile 100. They connect to a base panel that may be elastically forced into the sliding contacts 117. The electronics of the IC layer 102 connect to the sliding electrical contacts 117 via the substrate layer 103.

FIG. 2 illustrates a schematic representation of the tile 100. FIG. 2 illustrates a similar tile to the embodiment of FIG. 1; however, FIG. 2 illustrates a perspective view of the tile 100. The recesses 104 are shown to extend along the length of the tile 100 in a y-axis direction (not shown in FIG. 2). The recesses 104 are configured at two opposite sides of the tile 100 and at the lowest corners of these sides. The front side and the back side do not have the recesses but are substantially flat. Although, FIG. 2 illustrates the recesses 104 being configured at the two opposite sides, and front and back being flat, the recesses 104 may be configured to all four sides of the tile 100, also including the front side and the back side.

The compound semiconductor 101, the IC 102 and the substrate 103 establish a tile 100. One tile has an array of pixels, and each pixel corresponds to a signal pad on the compound semiconductor in digital imaging in the detector. The detector has an array (alternatively referred to as a matrix) of tiles 100.

FIG. 3 illustrates a schematic representation of a portion of an array of tiles 100 on an assembly frame 105 according to an embodiment. The tile 100 is assembled into a recess 106 of the assembly frame 105. The recess 106 is elongated in the y-axis direction. The tile 100 may be slid even when it is inserted into the recess 106. This may be possible for x-axis and/or y-axis directions. According to an embodiment, the tile 100 may be slid by +/- 100 um in both x-axis and y-axis directions. The recess 106 is configured to receive the bottom and the recesses 104 of the tile 100 so that the recesses 104 rest on the surface of the assembly frame 105 when the tile 100 is inserted into the recess 106. The tile 100 may be slid by approximately 100 um within the recess in the x-axis and/or y-axis direction corresponding to the width of the recess 106. The recess 106 is configured to accommodate the T shape of the tile 100.

FIG. 4 illustrates a schematic representation of an array of tiles 100 on an assembly frame 105 according to an embodiment. An embodiment of the array of the tiles 100 is shown in FIG. 4. It should be noted that the number of tiles 100 of the array and the shape of the array may vary. For example, there may be more or less than nine tiles 100. The shape may also be rectangular, oval or circular, even though a square is shown in FIG. 4. Gaps 119 between the tiles 100 are also shown. The gap 119, and consequently a distance between the neighboring tiles 100, may be assembled with a reasonable accuracy. A constant and certain level of distance may be achieved. This may improve the digital imaging and require less digital image correction.

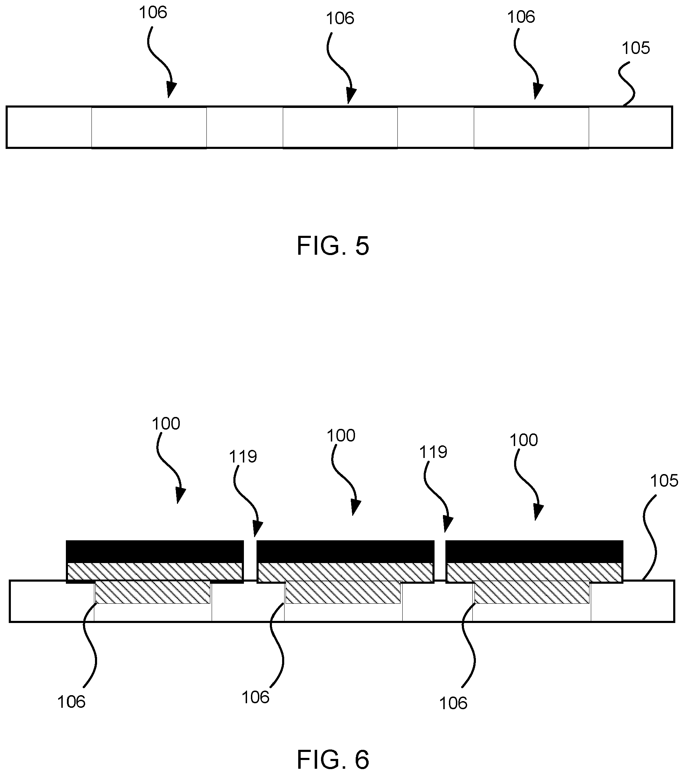

FIG. 5 illustrates a schematic representation of a cross section side view of a detector assembly process illustrating an assembly frame 105 according to an embodiment. Recesses 106 are manufactured in the assembly frame 105. For example, they may be carved in the frame 105 by a carving tool. The detector manufacturing process may start by making the recesses 106 in the frame 105.

FIG. 6 illustrates a schematic representation of a cross section side view of a detector assembly process illustrating tiles 100 on an assembly frame 105 according to an embodiment. The tiles 100 are assembled onto the frame 105. The base 103 of the tile 100 is inserted into the recess 106 of the frame 105. The cross sectional T-shape of the tile 100 fits into the recess so that the bottom of the tile 100 enters into the recess 106 and the shoulder (the recesses 104 of the tile 100) rests on the upper surface of the frame 105. When inserted, the tile 100 may be accurately positioned in x-axis and y-axis directions with respect to the tile array and any neighboring tile 100. Consequently, the gap 119 between the tiles 100 in the tile array may be accurately managed and controlled appropriately. Furthermore, the shoulders of the tile are thermally coupled to the frame assembly 105 so that they effectively conduct heat from the tile 100 towards the frame 105.

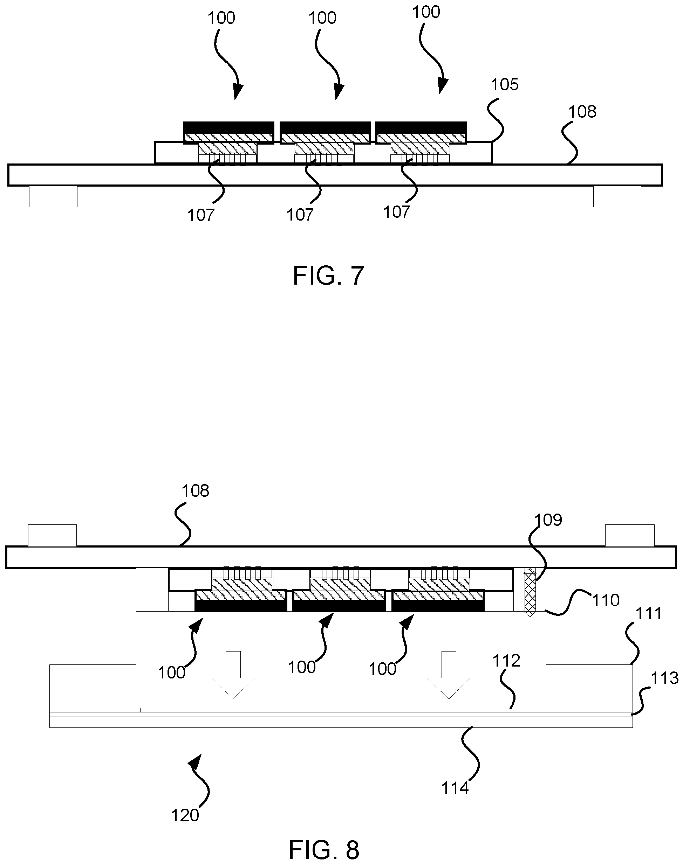

FIG. 7 illustrates a schematic representation of a cross section side view of a detector assembly process illustrating an interconnection printed circuit board assembly, PCBA, 108 having an assembly frame 105 and tiles 100 attached onto it according to an embodiment. The PCBA 108 serves as a larger assembly plate assembling the frame 105 into the larger frame assembly. Furthermore, FIG. 7 shows connectors 107. The connectors 107 electrically connect the sliding electrical contacts 117 from the tile 100 to the assembly frame 105. The connectors 107 may be forced to contact the electrical contacts 117, for example the connectors 107 are spring loaded SMD connectors. Consequently, the connectors 107 maintain the connection to the sliding contacts 117, even when there is small variance in the distance between the bottom of the tile 100 and the bottom of the recess 106. Furthermore, the connectors 107 remain in contact with the sliding connectors 117 even if the tile is slid along the x-axis and the y-axis. The end of the connector 107 slides on a surface of the sliding connector 117 when the tile 100 is repositioned in the recess 106.

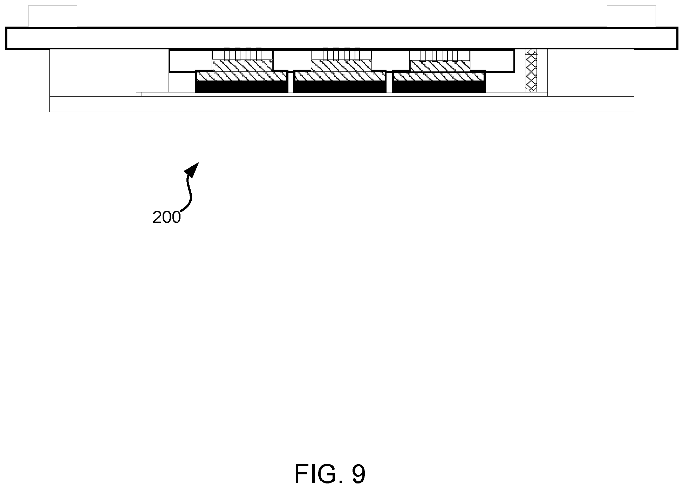

FIG. 8 illustrates a schematic representation of a cross section side view of a detector assembly process illustrating an assembly cover 120 and the PCBA 108 according to an embodiment. One end of the assembly frame 105 comprises a spring loaded pogo needle 109 which is surrounded by a thermal and electrical insulation frame 110. Another end has the frame 110 without the needle 109. The needle 109 is attached to the PCBA 108. The frame 110 is configured between the assembly frame 105 and the PCBA 108. The frame 110 is configured to thermally and electrically insulate the end of the assembly frame 105 and the tiles 100. Although FIG. 8 illustrates only one needle 109, it should be noted that there may be several needles, for example three. FIG. 8 illustrates an assembly cover 120. It comprises a thermally conductive frame 111 at the ends of the cover 120. When the cover 120 is assembled, as shown in FIG. 9, the thermally conductive frame 111 is connected to the PCBA 108 and is attached onto it. The cover 120 comprises a thermally conductive film 113. The film 113 is configured under the frame 111 and is thermally connected to it. The film 113 and the frame 111 effectively conduct heat that is emitted from the tiles 100 into the PCBA 108. An electrically conductive film 112 is configured on the thermally conductive film 113. The electrically conductive film 112 may be connected to the direct conversion compound semiconductor 101 and to the pogo needle 109. The cover 120 comprises a carbon fiber plate 114 protecting the detector and covering the surface of the detector. The plate 114 and the films 113, 112 may have a relatively small effect on x-ray radiation, and consequently for example the carbon fiber plate 114 may be minimized to a scale of 0.5-1.0 mm (maximum 2 mm). Consequently, the measures and configuration of the plate 114 and the films 113,112 are selected so that the radiation passes through them and enters into the semiconductor layer 101.

FIG. 9 illustrates a schematic representation of a cross section side view of a detector assembly process illustrating a complete assembly 200 according to an embodiment. The cover 120 has been assembled to the PCBA 108. The electrically conductive film 112 contacts the tiles 100 and the needle 109. Furthermore, the thermal frames 111 contact the PCBA 108 and sides of the frames 110.

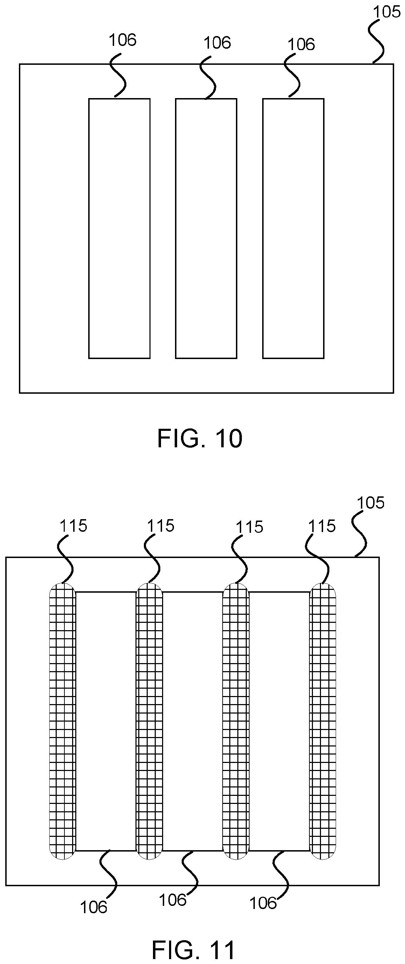

FIG. 10 illustrates a schematic representation of a top view of an assembly frame 105 showing recesses 106 for receiving tiles 100 according to an embodiment. The assembly frame 105 comprises elongated recesses 106. The embodiment of FIG. 10 illustrates three recesses 106, but it should be noted that the number of recesses may vary according to the tile array. The recesses 106 are parallel. The recesses 106 are positioned at a certain distance from each other. The bottom of the recesses 106 contains the connections 107 (not shown in FIG. 10). The width of the recesses 106 is slightly greater than the width of the bottom of the substrate layer 101. The length of the recess 106 is such that several tiles 100 fit to be assembled in the same recess 106. The depth of the recess 106 is such that the bottom of the the substrate layer 103, enters into the recess 106 and the shoulder of the recesses 104 contacts the surface of the assembly frame 105.

FIG. 11 illustrates a schematic representation of a top view of an assembly frame 105 showing adhesive strips 115 for attaching tiles 100 to the frame 105 according to an embodiment. The adhesive strips 115 are applied on a surface of the frame 105. The strips 115 conform to the shape of the recess 106 so that they are elongated and are positioned right next to the recess 106 on the surface of the frame 105. Between the recesses 106 the strips 115 may fill the whole area of the surface. When there is no neighboring recess 106, the strip 115 may fill an area approximately of the size of the area of the strip 115 between two recesses 106. The strip 115 may also extend beyond both ends of the recesses 106. According to an embodiment, the strip 115 may be made of adhesive tape. According to another embodiment, glue may be used instead of the adhesive tape. The adhesive strip 115 may conduct heat and/or conduct electricity. The force of adhesion of the strip 115 for a single tile 100 is such that the tile 100 may be detached from the array and the assembly frame 105 without the tile 100 being broken or corrupted. The adhesion attaches the tile 100 firmly to the assembly frame 105, yet even a single tile 100 of the whole array may be detached without any of the tiles 100 being broken or corrupted. Consequently, maintenance of the array is easy and cost effective, because the whole array of tiles 100 need not be replaced if a single tile 100 or a few tiles 100 are malfunctioning.

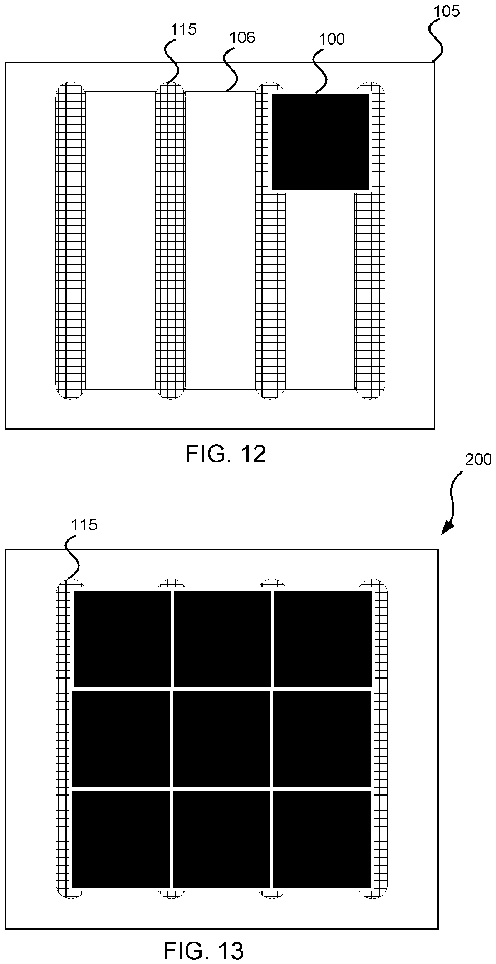

FIG. 12 illustrates a schematic representation of a top view of an assembly frame 105 showing a tile 100 assembled on a recess 106 and attached by adhesive strips 115 according to an embodiment. The tiles 100 may be assembled one-by-one to the assembly frame 105. FIG. 12 illustrates the assembly of the first tile 100 that is, by way of demonstration purposes only, positioned at the top and rightmost corner. However, it could be placed in a different location of the array as well.

FIG. 13 illustrates a schematic representation of a top view of an assembly frame 105 showing an array of tiles 100 assembled on recesses 106 and attached by adhesive strips 115 according to an embodiment. The recesses 106 are not illustrated in FIG. 13, except between two tiles 100 in the y-axis direction. Although the array has 3 ^{∗} 3 tiles 100, another kind of design may be used as well. For example, a rectangular, oval or circular array shape may be made of the tiles 100, instead of a square as illustrated in FIG. 13.

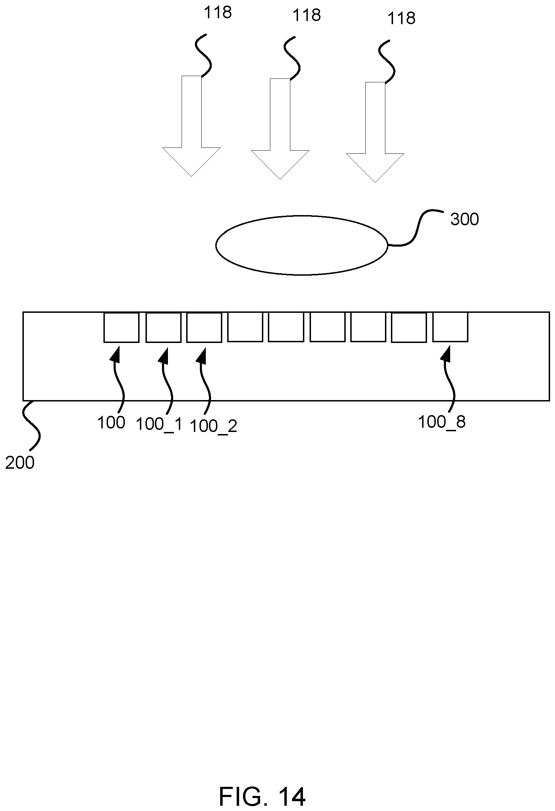

FIG. 14 illustrates a schematic representation of a cross section of a detector 200 having an array of tiles 100 according to an embodiment. X-ray radiation 118 is emitted from a source (not shown in FIG. 14). An object 300 to be detected and inspected by the x-ray radiation 118 is shown between the radiation source and the detector 200. The detector 200 comprises an array having nine tiles 100 - 100_8 in the cross section of the detector 200, for example in the x-axis direction.

FIG. 14 illustrates the detection devices 200 comprising tiles 100 having a T-shape cross section. The tiles 100 are slidingly assembled into the recesses 106 of the assembly frame 105. The assembly frame 105 has adhesive strips 115 to attach the tiles 100 to the frame 105 according to the embodiments. The device 200 may be a part of an imaging system for detecting the object 300, comprising the tiles 100 as described in any of these embodiments. The system may be applied for example in medical imaging, security imaging and/or industrial imaging.

Any range or device value given herein may be extended or altered without losing the effect sought. Also any embodiment may be combined with another embodiment unless explicitly disallowed.

Although the subject matter has been described in language specific to structural features and/or acts, it is to be understood that the subject matter defined in the appended claims is not necessarily limited to the specific features or acts described above. Rather, the specific features and acts described above are disclosed as examples of implementing the claims and other equivalent features and acts are intended to be within the scope of the claims.

Alternatively or in addition to the above, the concavities are configured to the lowest corners of the cross section of the substrate. Alternatively or in addition to the above, the concavities are configured to establish a T-shape for a cross section of the device having the direct conversion compound semiconductor layer, the IC layer and the substrate layer. Alternatively or in addition to the above, material of the substrate layer next to the concavities comprises thermally conductive material. Alternatively or in addition to the above, further including an assembly frame, wherein the assembly frame comprises recesses, each recess configured to receive a lowest part of the substrate layer being at a same level as the recesses, and an upper part of the substrate, which is above the recesses, rests on a surface of the assembly frame. Alternatively or in addition to the above, the assembly frame further includes elastic force loaded electrical connections at a bottom of the recesses, wherein the elastic force loaded electrical connections are configured to make contact with the sliding electrical contacts when the lowest part of the substrate enters the recess of the assembly frame and the upper part of the substrate rests on the surface of the assembly frame. Alternatively or in addition to the above, the contact between the sliding electric contacts of the substrate layer and the elastic force loaded electrical connections can be maintained when the device is slid in x-axis and y-axis directions. Alternatively or in addition to the above, the assembly frame further includes elongated adhesive strips on a top surface of the frame next to the recesses. Alternatively or in addition to the above, surfaces of the recesses of the substrate layer which rest on the adhesive strips adhere to the adhesive strips. Alternatively or in addition to the above, an adhesion force of the adhesive strip is low so that the substrate layer can be detached without any layers and the assembly frame being corrupted. Alternatively or in addition to the above, the direct conversion compound semiconductor layer comprises cadmium telluride or cadmium zinc telluride.

According to an embodiment, the device comprises a tile. Alternatively or in addition to the above, the tile can be slid so as to position the tile with respect to at least one neighboring tile.

According to an embodiment, a detector comprising an array of tiles according to above. According to another embodiment, an imaging system comprises: an x-ray source; the detector according to above.

It will be understood that the benefits and advantages described above may relate to one embodiment or may relate to several embodiments. The embodiments are not limited to those that solve any or all of the stated problems or those that have any or all of the stated benefits and advantages. It will further be understood that reference to 'an' item refers to one or more of those items.

The steps of the methods described herein may be carried out in any suitable order, or simultaneously where appropriate. Additionally, individual blocks may be deleted from any of the methods without departing from the spirit and scope of the subject matter described herein. Aspects of any of the examples described above may be combined with aspects of any of the other examples described to form further examples without losing the effect sought.

The term 'comprising' is used herein to mean including the method, blocks or elements identified, but that such blocks or elements do not comprise an exclusive list and a method or apparatus may contain additional blocks or elements.

It will be understood that the above description is given by way of example only and that various modifications may be made by those skilled in the art. The above specification, examples and data provide a complete description of the structure and use of exemplary embodiments. Although various embodiments have been described above with a certain degree of particularity, or with reference to one or more individual embodiments, those skilled in the art could make numerous alterations to the disclosed embodiments without departing from the scope of this specification.

## Claims

1. A device (100, 200), comprising:
a direct conversion compound semiconductor layer (101) configured to convert x-ray or gamma ray photons (118) into an electric current;
an integrated circuit, IC, layer (102) situated next to the direct conversion compound semiconductor layer with respect to a z-axis and configured to receive the electric current and process the electric current; and
a substrate layer (103) situated next to the IC layer with respect to the z-axis and configured to conduct heat emitted from the IC layer;
wherein the substrate layer comprises recesses (104) at corners of a cross section of the substrate; and
said device being **characterized in that** the substrate layer further comprises sliding electrical contacts (117) between the corners, the sliding electrical contacts being connected to the IC layer through the substrate layer to receive the processed electric current; and **in that** the device includes an assembly frame (105), wherein the assembly frame comprises additional recesses (106), each additional recess (106) being configured to receive a lowest part of the substrate layer being at a same level as the additional recesses (106), and an upper part of the substrate, which is above the additional recesses (106), rests on a surface of the assembly frame.

2. The device of claim 1, wherein the substrate layer is shorter in lateral dimension (104) than the IC layer located on the substrate layer.

3. The device of claim 1, wherein the recesses (104) are configured to the lowest corners of the cross section of the substrate.

4. The device of any preceding claim, wherein a cross section of the device having the direct conversion compound semiconductor layer, the IC layer and the substrate layer is configured to establish a T-shape.

5. The device of claim 1, wherein material of the substrate layer next to the recesses (104) comprises thermally conductive material.

6. The device of any preceding claim, wherein the assembly frame further includes elastic force loaded electrical connections (107) at a bottom of the additional recesses (106) wherein the elastic force loaded electrical connections are configured to make contact with the sliding electrical contacts when the lowest part of the substrate enters the additional recess (106) of the assembly frame and the upper part of the substrate rests on the surface of the assembly frame.

7. The device of any preceding claim, wherein the contact between the sliding electric contacts of the substrate layer and the elastic force loaded electrical connections can be maintained when the device is slid in x-axis and y-axis directions.

8. The device of any preceding claim, wherein the assembly frame further includes elongated adhesive strips (115) on a top surface of the frame next to the additional recesses (106).

9. The device of any preceding claim, wherein surfaces of the recesses (104) of the substrate layer which rest on the adhesive strips adhere to the adhesive strips.

10. The device of any preceding claim, wherein an adhesion force of the adhesive strip is low so that the substrate layer can be detached without any layers and the assembly frame being corrupted.

11. The device of any preceding claim, wherein the direct conversion compound semiconductor layer comprises cadmium telluride or cadmium zinc telluride.

12. The device of any preceding claim, wherein the device comprises a tile (100).

13. The device of any preceding claim, wherein the tile can be slid so as to position the tile with respect to at least one neighboring tile.

14. A detector (200) comprising an array of tiles (100) according to any preceding claim.

15. An imaging system, comprising:
a high energy radiation source;
the detector according to claim 14.

## Patentansprüche

1. Vorrichtung (100, 200), Folgendes umfassend:
eine Verbund-Halbleiterschicht zur Direktumwandlung (101), die dafür eingerichtet ist, Photonen der Röntgenstrahlung oder Gammastrahlung (118) in elektrischen Strom zu wandeln;
eine Schicht (102) einer integrierten Schaltung, IC, die sich entlang einer z-Achse benachbart zur Verbund-Halbleiterschicht zur Direktumwandlung befindet und die dafür eingerichtet ist, den elektrischen Strom aufzunehmen und den elektrischen Strom zu verarbeiten; und
eine Substratschicht (103), die sich entlang der z-Achse benachbart zur IC-Schicht befindet und die dafür eingerichtet ist, von der IC-Schicht abgegebene Wärme zu leiten;
wobei die Substratschicht in Ecken eines Querschnittes des Substrats Aussparungen (104) umfasst; und
wobei die Vorrichtung **dadurch gekennzeichnet ist, dass** die Substratschicht außerdem zwischen den Ecken verschiebbare elektrische Kontakte (117) umfasst und die verschiebbaren elektrischen Kontakte mit der IC-Schicht durch die Substratschicht verbunden sind, um den verarbeiteten elektrischen Strom zu empfangen;
und dadurch, dass die Vorrichtung einen Gruppenrahmen (105) umfasst, wobei der Gruppenrahmen zusätzliche Aussparungen (106) umfasst und jede zusätzliche Aussparung (106) dafür eingerichtet ist, einen untersten Teil der Substratschicht aufzunehmen, der sich auf derselben Höhe wie die zusätzlichen Aussparungen (106) befindet, und wobei ein oberer Teil des Substrats, der sich oberhalb der zusätzlichen Aussparungen (106) befindet, auf einer Oberfläche des Gruppenrahmens aufliegt.

2. Vorrichtung nach Anspruch 1, wobei die Substratschicht in der seitlichen Abmessung (104) kürzer ist als die IC-Schicht, die sich auf der Substratschicht befindet.

3. Vorrichtung nach Anspruch 1, wobei die Aussparungen (104) in den untersten Ecken des Substratquerschnitts eingerichtet sind.

4. Vorrichtung nach einem der vorhergehenden Ansprüche, wobei ein Querschnitt der Vorrichtung, die die Verbund-Halbleiterschicht zur Direktumwandlung, die IC-Schicht und die Substratschicht umfasst, dafür eingerichtet ist, eine T-Form zu bilden.

5. Vorrichtung nach Anspruch 1, wobei ein Material der Substratschicht benachbart zu den Aussparungen (104) wärmeleitendes Material umfasst.

6. Vorrichtung nach einem der vorhergehenden Ansprüche, wobei der Gruppenrahmen an einer Unterseite der zusätzlichen Aussparungen (106) außerdem elastische vorgespannte elektrische Anschlüsse (107) umfasst, wobei die elastischen vorgespannten elektrischen Anschlüsse dafür eingerichtet sind, einen Kontakt mit den verschiebbaren elektrischen Kontakten herzustellen, wenn der unterste Teil des Substrats in die zusätzlichen Aussparungen (106) des Gruppenrahmens eindringt und der obere Teil des Substrats auf der Oberfläche des Gruppenrahmens aufliegt.

7. Vorrichtung nach einem der vorhergehenden Ansprüche, wobei der Kontakt zwischen den verschiebbaren elektrischen Kontakten der Substratschicht und den elastischen vorgespannten elektrischen Anschlüssen aufrecht erhalten werden kann, wenn die Vorrichtung in den Richtungen der x-Achse und der y-Achse verschoben wird.

8. Vorrichtung nach einem der vorhergehenden Ansprüche, wobei der Gruppenrahmen außerdem langestreckte adhäsive Streifen (115) auf einer oberen Fläche des Rahmens benachbart zu den zusätzlichen Aussparungen (106) umfasst.

9. Vorrichtung nach einem der vorhergehenden Ansprüche, wobei Oberflächen der Aussparungen (104) der Substratschicht, die auf den adhäsiven Streifen aufliegen, an den adhäsiven Streifen haften.

10. Vorrichtung nach einem der vorhergehenden Ansprüche, wobei eine Adhäsionskraft des adhäsiven Streifens gering ist, derart, dass die Substratschicht ohne irgendwelche Schichten und eine Beschädigung des Gruppenrahmens abgelöst werden kann.

11. Vorrichtung nach einem der vorhergehenden Ansprüche, wobei die Verbund-Halbleiterschicht zur Direktumwandlung Cadmiumtellurid oder Cadmiumzinktellurid umfasst.

12. Vorrichtung nach einem der vorhergehenden Ansprüche, wobei die Vorrichtung eine Kachel (100) umfasst.

13. Vorrichtung nach einem der vorhergehenden Ansprüche, wobei die Kachel verschoben werden kann, um dadurch die Kachel in Bezug auf wenigstens eine benachbarte Kachel zu positionieren.

14. Detektor (200), der ein Array von Kacheln (100) nach einem der vorhergehenden Ansprüche umfasst.

15. Bildgebungssystem, Folgendes umfassend:
eine Quelle für Hochenergiestrahlung;
den Detektor nach Anspruch 14.

## Revendications

1. Dispositif (100, 200) comprenant :
une couche en composé semi-conducteur à conversion directe (101) configurée pour convertir des photons à rayon gamma ou rayon x (118) en un courant électrique ;
une couche de circuit intégré, CI, (102) située près de la couche en composé semi-conducteur à conversion directe par rapport à un axe z et configurée pour recevoir le courant électrique et traiter le courant électrique ; et
une couche de substrat (103) située près de la couche de CI par rapport à l'axe z et configurée pour conduire de la chaleur émise par la couche de CI ;
dans lequel la couche de substrat comprend des évidements (104) à des coins d'une section transversale du substrat ; et
ledit dispositif étant **caractérisé en ce que**
la couche de substrat comprend en outre des contacts électriques coulissants (117) entre les coins,
les contacts électriques coulissants étant raccordés à la couche de CI au travers de la couche de substrat pour recevoir le courant électrique traité ;
et **en ce que** le dispositif inclut un cadre d'ensemble (105), dans lequel le cadre d'ensemble comprend des évidements supplémentaires (106), chaque évidement supplémentaire (106) étant configuré pour recevoir une partie la plus basse de la couche de substrat qui est à un même niveau que les évidements supplémentaires (106), et une partie supérieure du substrat qui est au-dessus des évidements supplémentaires (106), repose contre une surface du cadre d'ensemble.

2. Dispositif selon la revendication 1, dans lequel la couche de substrat est plus courte dans la dimension latérale (104) que la couche de CI située sur la couche de substrat.

3. Dispositif selon la revendication 1, dans lequel les évidements (104) sont configurés sur les coins les plus bas de la section transversale du substrat.

4. Dispositif selon l'une quelconque des revendications précédentes, dans lequel une section transversale du dispositif présentant la couche en composé semi-conducteur à conversion directe, la couche de CI et la couche de substrat est configurée pour établir une forme en T.

5. Dispositif selon la revendication 1, dans lequel du matériau de la couche de substrat près des évidements (104) comprend un matériau thermoconducteur.

6. Dispositif selon l'une quelconque des revendications précédentes, dans lequel le cadre d'ensemble inclut en outre des connexions électriques chargées par force élastique (107) sur un fond des évidements supplémentaires (106), dans lequel les connexions électriques chargées par force élastique sont configurées pour faire contact avec les contacts électriques coulissants lorsque la partie la plus basse du substrat entre dans l'évidement supplémentaire (106) du cadre d'ensemble et la partie supérieure du substrat repose contre la surface du cadre d'ensemble.

7. Dispositif selon l'une quelconque des revendications précédentes, dans lequel le contact entre les contacts électriques coulissants de la couche de substrat et les connexions électriques chargées par force élastique peut être maintenu lorsque le dispositif est coulissé dans des directions d'axe x et axe y.

8. Dispositif selon l'une quelconque des revendications précédentes, dans lequel le cadre d'ensemble inclut en outre des bandes adhésives allongées (115) sur une surface supérieure du cadre près des évidements supplémentaires (106).

9. Dispositif selon l'une quelconque des revendications précédentes, dans lequel des surfaces des évidements (104) de la couche de substrat qui reposent contre les bandes adhésives adhèrent aux bandes adhésives.

10. Dispositif selon l'une quelconque des revendications précédentes, dans lequel une force d'adhésion de la bande adhésive est faible de sorte que la couche de substrat puisse être détachée sans couche ni endommagement du cadre d'ensemble.

11. Dispositif selon l'une quelconque des revendications précédentes, dans lequel la couche en composé semi-conducteur à conversion directe comprend du tellurure de cadmium ou tellurure de zinc de cadmium.

12. Dispositif selon l'une quelconque des revendications précédentes, dans lequel le dispositif comprend une tuile (100).

13. Dispositif selon l'une quelconque des revendications précédentes, dans lequel la tuile peut être coulissée de sorte à positionner la tuile par rapport à au moins une tuile voisine.

14. Détecteur (200) comprenant un agencement de tuiles (100) selon une quelconque revendication précédente.

15. Système d'imagerie comprenant :
une source de rayonnement à haute énergie ;
le détecteur selon la revendication 14.
